# EUROPÄISCHE PATENTSCHRIFT

(11) **EP 2 327 284 B1**
(45) Veröffentlichungstag und Bekanntmachung des Hinweises auf die Patenterteilung: **28.12.2016**
(21) Anmeldenummer: 09781640.9
(22) Anmeldetag: 07.08.2009
(51) Int. Cl.: H05K 3/32, G01K 1/14, G01K 7/22

(54) **SENSORVORRICHTUNG UND VERFAHREN ZUR HERSTELLUNG**
SENSOR DEVICE AND METHOD FOR MANUFACTURE
DISPOSITIF DÉTECTEUR ET PROCÉDÉ DE PRODUCTION

(30) Priorität: 07.08.2008 DE 102008036837
(43) Veröffentlichungstag der Anmeldung: 01.06.2011
(73) Patentinhaber: Epcos AG, 81669 München (DE)
(72) Erfinder: KLOIBER, Gerald, A-8073 Feldkirchen (AT); STRALLHOFER, Heinz, A-8530 Deutschlandsberg (AT); FREIBERGER, Norbert, A-8054 Graz-Strassgang (AT)
(74) Vertreter: Epping - Hermann - Fischer
(86) Internationale Anmeldenummer: PCT/EP2009/060306
(87) Internationale Veröffentlichungsnummer: WO 2010/015717

(56) Entgegenhaltungen:
- DE-A1-102006 031 344
- US-A- 4 447 799
- US-A- 5 561 411
- US-A- 5 600 296
- US-B1- 6 248 978

## Beschreibung

Aus der Druckschrift DE 102006031344 A1 ist eine Sensoranordnung bekannt, bei dem ein Sensorelement in einer Plattenanordnung angeordnet ist.

Aus der Druckschrift US 6,248,978 B1 ist ferner eine Sensorvorrichtung zur Temperaturmessung bekannt, bei der ein Thermistorbauelement mittels einer Lotschicht, einer Schicht aus elektrisch leitendem Harz oder einer elektrisch leitenden Glaspaste mit auf einem Trägersubstrat angeordneten Leiterbahnen verbunden ist.

Eine zu lösende Aufgabe ist es, eine Sensorvorrichtung anzugeben, die einen einfachen und stabilen Aufbau aufweist.

Die zu lösende Aufgabe wird durch eine Sensorvorrichtung nach Patentanspruch 1 gelöst. Des Weiteren wird die Aufgabe durch ein Verfahren zur Herstellung einer Sensorvorrichtung nach Anspruch 14 und 15 gelöst. Vorteilhaften Ausgestaltungen der Sensorvorrichtung sowie der Herstellung des Verfahrens, sind Gegenstand von Unteransprüchen.

Es wird eine Sensorvorrichtung angegeben, die ein keramisches Trägersubstrat umfasst, wobei auf dem Trägersubstrat wenigstens zwei Leiterbahnen angeordnet sind. Die Sensorvorrichtung weist wenigstens ein keramisches Bauelement in Chipform auf, das mit den Leiterbahnen des keramischen Trägersubstrats elektrisch leitend verbunden ist.

Das keramische Bauelement umfasst vorzugsweise einen temperaturabhängigen Widerstand, mittels dessen eine erfasste physikalische Größe in ein elektrisches Signal umgewandelt werden kann.

Die folgenden Merkmale des keramischen Bauelements werden beispielhaft für ein beziehungsweise mehrere NTC-Elemente beschrieben.

Die folgenden Merkmale gelten jedoch auch für ein beliebiges anderes keramisches Bauelement, das dazu geeignet ist, eine physikalische Größe in ein elektrisches Messsignal umzuwandeln.

Das keramische Bauelement ist vorzugsweise als temperaturbeständiger Temperaturfühler ausgebildet. In einer vorteilhaften Ausführungsform ist das keramische Bauelement als NTC-Element ausgebildet und umfasst einen Körper, der NTC-Keramik enthält. NTC steht hierbei für Negative Temperature Coefficient. Das NTC-Element liegt vorzugsweise als ungehäuster keramischer Chip vor. Die NTC-Keramik ist vorzugsweise alterungsbeständig. Die NTC-Keramik weist vorzugsweise eine hohe Empfindlichkeit hinsichtlich einer Temperaturmessung auf. Die NTC-Keramik umfasst beispielsweise eine Mangan-Nickel-Keramik, die vorzugsweise eine Spinellstruktur aufweist.

Das wenigstens eine NTC-Element ist mittels einer eingebrannten Siebdruckpaste mit den Leiterbahnen des keramischen Trägersubstrats der Sensorvorrichtung mechanisch fest verbunden. Durch eine mechanische Verbindung des NTC-Elements mittels Siebdruckpaste mit dem Trägersubstrat wird eine lotfreie Verbindung erreicht, die für die Erfassung von hohen Temperaturen geeignet ist. Vorzugsweise werden silberhaltige oder silber-platinhaltige Siebdruckpasten verwendet.

Verbindungen mittels Loten weisen einen eingeschränkten Einsatzbereich auf, da sie bereits bei relativ niedrigen Temperaturen einem Übergangsbereich zwischen fest, bei ihrer Solidustemperatur, und flüssig, bei der Liquidustemperatur, erreichen und dadurch nicht mehr für eine stabile Verbindung geeignet sind.

In einer Ausführungsform weist die Sensorvorrichtung wenigstens zwei NTC-Elemente auf die parallel zueinander geschaltet sind.

In einer weiteren Ausführungsform kann die Sensorvorrichtung zwei NTC-Elemente aufweisen, die seriell zueinander geschaltet sind.

In einer weiteren Ausführungsform ist es auch möglich, dass sowohl parallel geschaltete als auch seriell zueinander geschaltete NCT-Elemente auf dem Trägersubstrat der Sensorvorrichtung angeordnet sind.

In einer Ausführungsform sind vorzugsweise zwei NTC-Elemente, die auf unterschiedlichen Leiterbahnen des Trägersubstrats angeordnet sind, mittels einer elektrisch leitenden Brücke miteinander verbunden. In einer Ausführungsform umfasst die Brücke das gleiche Material wie das Trägersubstrat der Sensorvorrichtung.

In einer Ausführungsform, die beispielsweise mehrere NTC-Elemente aufweist, ist die Sensorvorrichtung auch zur Erfassung mehrerer Einzeltemperaturen oder der Durchschnittstemperatur eines inhomogenen Temperaturfeldes ausgelegt.

In einer Ausführungsform weist die Sensorvorrichtung wenigstens zwei NTC-Elemente auf, wobei jedes NTC-Elemente mittels wenigstens einer separaten Leiterbahn elektrisch kontaktiert sind.

In einer weiteren Ausführungsform weisen beispielsweise wenigstens zwei NTC-Elemente einer Sensorvorrichtung wenigstens eine gemeinsame Leiterbahn auf, über die die NTC-Elemente gemeinsam elektrisch kontaktiert sind.

Durch eine Sensorvorrichtung mit zwei oder mehreren NTC-Elementen kann bei geeigneter Ausführung der Leiterbahnen die Temperatur gleichzeitig an verschiedenen Stellen gemessen werden. Dazu können die NTC-Elemente in Serie, parallel oder unabhängig voneinander über separate Leiterbahnen elektrisch kontaktiert sein.

Eine wie oben beschriebene Sensorvorrichtung ist insbesondere für die Erfassung von mehreren Temperaturen eines inhomogenen Temperaturfeldes geeignet, wenn sie mit mehreren NTC-Elementen bestückt ist. Bei einer Sensorvorrichtung mit mindestens zwei Elementen ist es möglich, die Temperaturen eines inhomogenen Temperaturfeldes zu erfassen.

Durch oben beschriebene Sensorvorrichtung ist diese insbesondere dafür geeignet, Temperaturen im Bereich von bis zu 1000 °C zu erfassen. In einer bevorzugten Ausführungsform ist die Sensorvorrichtung insbesondere dafür geeignet, Temperaturen im Bereich von 300 °C zu erfassen. Durch die Verwendung eines keramischen Trägersubstrats und einer lötfreien Befestigung des Sensors auf dem Substrat ist die Sensorvorrichtung für die Erfassung von Temperaturen bis zu 1000 °C geeignet. Prinzipiell ist der Einsatzbereich der Sensorvorrichtung nur durch die verwendete NTC-Keramik beschränkt, da NTC-Keramiken ab einer gewissen Temperatur zu driften beginnen.

In einer Ausführungsform umfasst das NTC-Element einen keramischen Chip, der vorzugsweise einen direkten elektrischen Kontakt zu wenigstens einer der Leiterbahnen aufweist. In einer weiteren Ausführungsform weist der keramische Chip einen elektrischen Kontakt zu wenigstens zwei Leiterbahnen auf.

In einer Ausführungsform weist der keramische Chip des NTC-Elements auf seinen Oberflächen eine vollflächige Kontaktfläche auf. Vorzugsweise ist die Kontaktfläche in Form einer Metallisierung aus elektrisch leitfähiger Siebdruckpaste auf zwei gegenüber liegenden Oberflächen des NTC-Elements aufgebracht, die Anschlussbereiche des Bauelements bilden.

In einer weiteren Ausführungsform ist die Metallisierung aus elektrisch leitfähiger Siebdruckpaste streifenförmig aufgebracht, wobei die Metallisierung vorzugsweise im Bereich zweier gegenüber liegender Seitenkanten aufgebracht ist. Dadurch lässt sich der Widerstand des keramischen Bauelements sehr genau einstellen. Vorzugsweise überlappt die Metallisierung die Seitenkanten zu den Hauptflächen des NTC-Elements. Die Metallisierungen bilden Anschlussbereiche des Bauelement über die das Bauelement elektrisch kontaktierbar ist.

In einer weiteren Ausführungsform sind die NTC-Elemente frei von Metallisierungen.

NTC-Elemente, die eine beidseitige vollflächige Metallisierung aus elektrisch leitfähiger Siebdruckpaste aufweisen, sind besonders für eine serielle Verschaltung mittels einer elektrisch leitenden Brücke geeignet. Bei einem einfachen Aufbau der Sensorvorrichtung, bei der nur ein oder mehrere parallel zueinander verschaltete NTC-Elemente Verwendung finden, weisen die NTC-Elemente vorzugsweise eine streifenförmige Metallisierung aus elektrisch leitfähiger Siebdruckpaste im Bereich der Seitenkanten auf.

Um eine Kontaktierung eines flachen NTC-Elements in einer Ebene zu ermöglichen, ist die Metallisierung aus elektrisch leitfähiger Siebdruckpaste des NTC-Elements vorzugsweise streifenförmig ausgeführt. In einer weiteren Ausführungsform kann das NTC-Element jedoch auch frei von Metallisierungen sein. Bei einer metallisierungsfreien Ausführungsform des NTC-Elements wird dieses während des Einbrennens der Siebdruckpaste durch die eingebrannte Siebdruckpaste kontaktiert. Hierbei wird ein metallisierungsfreies NTC-Element auf einer uneingebrannten Siebdruckpaste angeordnet, die die Leiterbahnen bildet, und in einem gemeinsamen Brennverfahren eingebrannt.

Vorzugsweise ist das keramische Trägersubstrat aus einem gut wärmeleitenden Material gebildet. Bei einer Sensorvorrichtung mit einer oder mehreren thermisch gut angekoppelten NTC-Elementen ist so die Erfassung der mittleren Temperatur eines Temperaturfeldes möglich.

Vorzugsweise umfassen die Leiterbahnen einen metallischen Werkstoff, dessen Schmelzpunkt über der oberen Anwendungstemperatur der Sensorvorrichtung liegt. Dadurch ist eine hinreichend gute Temperaturstabilität der Leiterbahn gewährleistet.

In einer Ausführungsform weist das Trägersubstrat eine Dicke auf, die kleiner ist als die sonstigen Abmessungen. Der Durchmesser bei einem kreisförmigen Trägersubstrat sowie die Länge oder die Breite bei einem eckigen Trägersubstrats sind vorzugsweise größer als die Dicke des Trägersubstrats. Das Trägersubstrat weist in einer Ausführungsform eine rechteckige Grundfläche auf. Die Form des Trägersubstrats kann jedoch jede beliebige Form aufweisen.

Durch ein Trägersubstrat mit einer sehr geringen Dicke und durch die Verwendung von NTC-Elementen in Form ungehäuster keramischer Chips kann die gesamte Bauhöhe der Sensorvorrichtung sehr gering gehalten werden.

In einer Ausführungsform ist das keramische Trägersubstrat in einem weiten Temperaturbereich, mindestens jedoch bis zur oberen Anwendungstemperatur, als elektrischer Isolator anzusehen. Dadurch ist beispielsweise eine hinreichend gute elektrische Isolation zwischen einem Trägersubstrat, bei dem auf einer ersten Seite Leiterbahnen aufgedruckt sind, und der zweiten gegenüber liegenden Seite des Trägersubstrats gewährleistet.

Vorzugsweise umfasst die Sensorvorrichtung derartige Materialien und Werkstoffe, dass eine Wechselwirkung zwischen der Sensorvorrichtung und einem externen zeitabhängigen Magnetfeld als vernachlässigbar angesehen werden kann.

Zur Herstellung einer Sensorvorrichtung wird ein Verfahren angegeben, bei dem auf einem bereitgestellten keramischen Trägersubstrat wenigstens ein chipförmiges NTC-Element mittels einer einbrennbaren elektrisch leitfähigen Siebdruckpaste mit dem Trägersubstrat mechanisch fest verbunden wird.

Bei einer ersten Ausführungsform des Verfahrens zur Herstellung einer Sensorvorrichtung wird auf einem bereitgestellten keramischen Trägersubstrat eine elektrisch leitfähige Siebdruckpaste aufgebracht, die wenigstens zwei Leiterbahnen auf dem Trägersubstrat ausbildet. Auf dem Trägersubstrat wird wenigstens ein NTC-Element angeordnet, wobei das NTC-Element die aufgedruckte Siebdruckpaste über wenigstens zwei Anschlussbereiche des NTC-Elements elektrisch kontaktiert. Die Anschlussbereiche sind durch eine auf das NTC-Element aufgebrachte elektrisch leitfähige Siebdruckpaste gebildet. Wenigstens ein erster Anschlussbereich des NTC-Elements weist einen direkten elektrischen Kontakt zu der Siebdruckpaste auf. Ein zweiter Anschlussbereich kann entweder einen direkten oder auch einen indirekten elektrischen Kontakt beispielsweise über eine Kontaktbrücke und ein weiteres NTC-Element aufweisen. Die Siebdruckpaste wird in einem weiteren Verfahrensschritt in das keramische Trägersubstrat und das NTC-Element eingebrannt. Durch das Einbrennen der Siebdruckpaste in das keramische Trägersubstrat und das NTC-Element bilden das wenigstens eine NTC-Element, das Trägersubstrat und die eingebrannte Siebdruckpaste während des Brennvorgangs eine mechanisch stabile Verbindung.

Bei einer weiteren Ausführungsform eines Verfahrens zur Herstellung einer Sensorvorrichtung wird auf einem bereitgestellten keramischen Trägersubstrat eine Siebdruckpaste aufgebracht, die wenigstens zwei Leiterbahnen auf dem Trägersubstrat bildet. In einem ersten Brennvorgang wird die Siebdruckpaste in das keramische Trägersubstrat eingebrannt. Anschließend wird auf den Leiterbahnen wenigstens ein NTC-Element angeordnet, wobei das NTC-Element mittels einer aufgebrachten elektrisch leitfähigen Siebdruckpaste nach deren Einbrennen wenigstens einen elektrischen Kontakt zu den Leiterbahnen aufweist. Das wenigstens eine NTC-Element kann zu einer weiteren eingebrannten Leiterbahn entweder einen direkten oder einen indirekten elektrischen Kontakt aufweisen. In einem zweiten Brennvorgang gehen das wenigstens eine NTC-Element und die auf die Leiterbahnen aufgebrachte Siebdruckpaste während des Brennvorgangs eine mechanisch stabile Verbindung ein.

Die oben beschriebenen Gegenstände werden anhand der folgenden Figuren und Ausführungsbeispielen näher erläutert.

Die nachfolgend beschriebenen Zeichnungen sind nicht als maßstabsgetreu aufzufassen. Vielmehr können zur besseren Darstellung einzelne Dimensionen vergrößert, verkleinert oder auch verzerrt dargestellt sein. Elemente die einander gleichen, oder die die gleichen Funktionen übernehmen, sind mit den gleichen Bezugszeichen bezeichnet.
- Figur 1: zeigt ein keramisches Trägersubstrat,
- Figur 2: zeigt eine Ausführungsform eines keramischen Bauelements als NTC-Element mit streifenförmigen Metallisierungen,
- Figur 3: zeigt eine erste Ausführungsform der Sensorvorrichtung mit einem NTC-Element,
- Figur 4: zeigt eine weitere Ausführungsform der Sensorvorrichtung mit zwei NTC-Elementen, die parallel zueinander geschaltet sind,
- Figur 5: zeigt eine weitere Ausführungsform der Sensorvorrichtung mit vier NTC-Elementen, von denen jeweils zwei in Serie geschaltete NTC-Elemente parallel zueinander geschaltet sind.

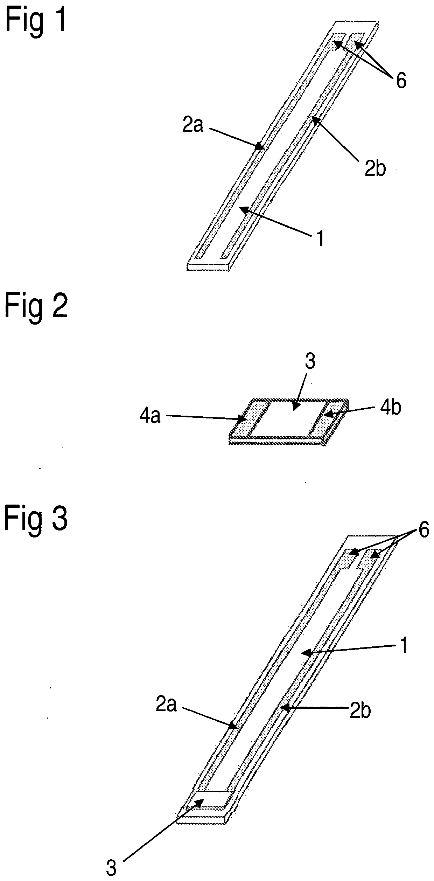

In der Figur 1 ist ein keramisches Trägersubstrat 1 einer ersten Ausführungsform der Sensorvorrichtung gezeigt. Das keramische Trägersubstrat 1 weist bevorzugt im Bereich seiner Dicke die geringsten Abmessungen auf. Auf dem keramischen Trägersubstrat 1 sind zwei Leiterbahnen 2a, 2b angeordnet, die mittels eines Siebdruckverfahrens auf dem Trägersubstrat 1 aufgebracht wurden. Zur Herstellung der Leiterbahnen 2a, 2b wurde beispielsweise eine silberhaltige oder silber-platinhaltige Siebdruckpaste auf das Trägersubstrat 1 mittels eines Siebdruckverfahrens aufgebracht.

Die Siebdruckpaste wird unter der Einwirkung von sehr hohen Temperaturen in das keramische Trägersubstrat 1 und das keramische Bauelement eingebrannt. Das Einbrennen erfolgt vorzugsweise bei Temperaturen im Bereich von etwa 700 °C bis 900 °C.

Die eingebrannte Siebdruckpaste bildet die Leiterbahnen 2a, 2b auf vorzugsweise einer Oberseite des Trägersubstrats 1 aus. In der dargestellten Ausführungsform weisen die Leiterbahnen 2a, 2b im Bereich eines Endes des Trägersubstrats 1 Kontaktbereiche 6 auf. Die Kontaktbereiche 6 können beispielsweise als separate Anschlusspads, in Form von verbreiterten Leiterbahnen oder in anderweitiger Form vorliegen. Die Kontaktbereiche 6 dienen zur elektrischen Kontaktierung der Sensorvorrichtung. Vorzugsweise sind die Kontaktbereiche 6, wie in der Figur 1 dargestellt, von einer gemeinsamen Seite des Trägersubstrats 1 zugänglich. Es ist jedoch auch möglich, dass die Kontaktbereiche 6 mittels Durchkontaktierungen auf unterschiedlichen Seiten des Trägersubstrats 1 angeordnet sind.

Auf das Trägersubstrat 1 wird in einer möglichen Ausführungsform wenigstens ein keramisches Bauelement, das in den Figuren 2 bis 5 beispielhaft als NTC-Element dargestellt ist, angeordnet und direkt mit der Siebdruckpaste erhitzt. Alternativ kann wenigstens ein keramisches Bauelement auch in einem weiteren separaten Einbrennschritt mittels einer Siebdruckpaste mit den Leiterbahnen 2a, 2b verbacken werden.

Die Figur 2 zeigt eine Ausführungsform eines keramischen Bauelements als NTC-Element 3. Das NTC-Element 3 liegt vorzugsweise in der Form eines ungehäusten keramischen Chips (Die) vor. In der dargestellten Ausführungsform weist das NTC-Element 3 im Bereich zweier gegenüberliegender Seitenkanten auf einer Oberfläche des NTC-Elements 3 streifenförmige Metallisierungen 4a, 4b auf, die über die Seitenbereiche des NTC-Elements 3, bis zu dessen Seitenkanten reichen können. Es ist auch möglich, dass die streifenförmige Metallisierungen 4a, 4b über die Seitenkanten hinaus bis auf die gegenüberliegende Unterseite des NTC-Elements 3 reichen. Durch eine streifenförmige Metallisierung 4a, 4b wird das NTC-Element 3 beispielsweise über zwei nebeneinander liegende Leiterbahnen nach dem Einbrennen der Siebdruckpaste elektrisch kontaktiert werden.

In einer weiteren nicht dargestellten Ausführungsform kann die Metallisierung 4 aus einer elektrisch leitfähigen Siebdruckpaste auch vollflächig auf der Ober- und Unterseite des NTC-Elements 3 aufgebracht sein. Bei dieser Ausführungsform stellt eine erste metallisierte Seite des NTC-Elements 3 nach dem Einbrennen der Siebdruckpaste einen ersten elektrischen Kontakt zu einer Leiterbahn oder einem weiteren elektrischen Bauelement dar. Über die zweite metallisierte Seite des NTC-Elements 3 wird der zweite elektrische Kontakt des NTC-Elements 3 elektrisch kontaktiert.

In der Figur 3 ist eine erste Ausführungsform der Sensorvorrichtung mit einem NTC-Element 3 dargestellt. Das NTC-Element 3 ist in einem Endbereich direkt mit den Leiterbahnen 2a, 2b des Trägersubstrats 1 elektrisch leitend verbunden. Das NTC-Element 3 weist in der dargestellten Ausführungsform vorzugsweise streifenförmige Metallisierungen aus elektrisch leitfähiger Siebdruckpaste im Bereich der Seitenkanten auf, die in der Figur 3 nicht dargestellt sind, da sie in dieser Ausführungsform vorzugsweise auf der Unterseite des NTC-Elements 3 angeordnet sind. Das NTC-Element 3 ist mit den Leiterbahnen 2a, 2b temperaturbeständig und mechanisch fest, sowie elektrisch verbunden. Das NTC-Element 3 ist mittels einer Siebdruckpaste mit den Leiterbahnen 2a, 2b verbunden. In einem Brennschritt wird das NTC-Element 3 mit der Siebdruckpaste der Leiterbahnen 2a, 2b, beziehungsweise mit einer extra auf die bereits eingebrannten Leiterbahnen 2a, 2b aufgebrachten Siebdruckpaste verbacken, so dass eine hochtemperaturbeständig, elektrisch leitfähige und mechanisch stabile Verbindung zwischen den Leiterbahnen 2a, 2b des Trägersubstrats 1 und dem NTC-Element 3 erfolgt.

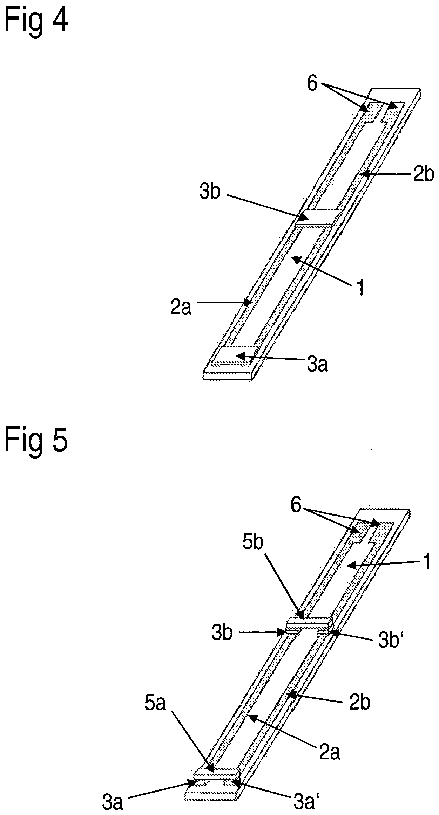

Die Figur 4 zeigt eine weitere Ausführungsform der Sensorvorrichtung, bei der zwei NTC-Elemente 3a, 3b parallel zueinander geschaltet sind. Die zwei NTC-Elemente 3a, 3b sind vorzugsweise bezüglich der längsten Ausdehnung des Trägersubstrats 1 voneinander beabstandet angeordnet. Die NTC-Elemente 3a, 3b sind in der dargestellten Ausführungsform über die Leiterbahnen 2a, 2b zueinander parallel geschalten. Durch eine Anordnung, bei der die NTC-Elemente 3a, 3b voneinander beabstandet auf dem Trägersubstrat 1 angeordnet sind, ist es beispielsweise möglich, die Durchschnittstemperatur eines inhomogenen Temperaturfeldes zu erfassen. Das erste NTC-Element 3a erfasst die Temperatur in einem ersten Bereich des inhomogenen Temperaturfeldes und das zweite NTC-Element 3b erfasst die Temperatur in einem zweiten Bereich, wobei sich die Temperaturen des ersten und zweiten Bereichs voneinander unterscheiden. Das Ausgangssignal der beiden NTC-Elemente 3a, 3b ergibt ein elektrisches Signal, mit Hilfe dessen beispielsweise die Durchschnittstemperatur der beiden Temperaturbereiche ermittelt werden kann.

In einer weiteren, nicht dargestellten Ausführungsform können beispielsweise zwei NTC-Elemente eine gemeinsame Hinleitung und voneinander getrennte Rückleitungen aufweisen. Dadurch ist es beispielsweise möglich, die unterschiedlichen Temperaturen eines inhomogenen Temperaturfeldes getrennt voneinander vorzugsweise zeitgleich zu ermitteln.

Durch die Verwendung von mehr als zwei NTC-Elementen kann beispielsweise bei einer Parallelschaltung eine exaktere Durchschnittstemperatur eines inhomogenen Temperaturfeldes ermittelt werden. Bei einer Verschaltung mit getrennten Rückleitungen können so mehrere Temperaturen eines inhomogenen Temperaturfeldes ermittelt werden.

In der Figur 5 ist eine weitere Ausführungsform der Sensorvorrichtung mit vier NTC-Elementen 3a, 3a', 3b, 3b' dargestellt, wobei jeweils zwei, in Serie geschaltete NTC-Elemente 3a, 3a' und 3b, 3b', parallel zueinander geschaltet sind. Die NTC-Elemente 3a, 3a', 3b, 3b' weisen in der dargestellten Ausführungsform vorzugsweise eine beidseitige, vollflächige Metallisierung aus elektrisch leitfähiger Siebdruckpaste auf, die in der Figur 5 nicht dargestellt ist. Zur Kontaktierung der NTC-Elemente 3a, 3a', 3b, 3b' weisen diese mit einer ersten Seite vorzugsweise einen direkten Kontakt zu einer der beiden Leiterbahnen 2a, 2b auf dem Trägersubstrat 1 auf. Über die zweite Seite der NTC-Elemente 3a, 3a', 3b, 3b' sind jeweils zwei erste NTC-Elemente 3a, 3a' mittels einer elektrisch leitenden Kontaktbrücke 5a elektrisch miteinander verbunden. Das zweite Paar der NTC-Elemente 3b, 3b' ist ebenfalls mittels einer elektrisch leitenden Kontaktbrücke 5b elektrisch miteinander verbunden. Die Kontaktbrücken 5a, 5b umfassen vorzugsweise das gleiche keramische Material wie das Trägersubstrat 1. Die Kontaktbrücken 5a, 5b weisen wenigstens eine Leiterbahn auf, mittels der wenigstens zwei NTC-Elemente 3a, 3a' beziehungsweise 3b, 3b' miteinander elektrisch verbunden sind.

Die NTC-Elemente 3a, 3a', 3b, 3b' sind vorzugsweise mittels beidseitig aufgetragener elektrisch leitfähiger Siebdruckpaste mit den Leiterbahnen 2a, 2b beziehungsweise mit der elektrisch leitenden Kontaktbrücken 5a, 5b mechanisch und elektrisch verbunden. Die Verbindung der ersten Seiten der NTC-Elemente 3a, 3a', 3b, 3b' mit den Leiterbahnen 2a, 2b mittels Siebdruckpaste kann auch bereits zusammen mit dem Einbrennen der Siebdruckpaste der Leiterbahnen 2a, 2b in das keramische Trägersubstrat 1 erfolgen. In einer Ausführungsform ist es auch möglich, dass auch die Verbindungen der zweiten Seiten der NTC-Elemente 3a, 3a', 3b, 3b' zu den jeweiligen elektrisch leitenden Kontaktbrücken 5a, 5b mittels elektrisch leitfähiger Siebdruckpaste in einem ersten gemeinsamen Brennschritt, zusammen mit dem Einbrennen der Leiterbahnen 2a, 2b erfolgt.

Obwohl in den Ausführungsbeispielen nur eine beschränkte Anzahl möglicher Weiterbildungen der Erfindung beschrieben werden konnte ist die Erfindung nicht auf diese beschränkt. Es ist prinzipiell möglich, dass die Sensorvorrichtung mehrere NTC-Elemente aufweist, die über separate Leiterbahnen angeschlossen sind, so dass die unterschiedlichen Temperaturen eines inhomogenen Temperaturfeldes erfasst werden können.

Die Erfindung ist nicht auf die Anzahl der dargestellten Elemente beschränkt.

Die Beschreibung der hier angegebenen Gegenstände ist nicht auf die einzelnen speziellen Ausführungsformen beschränkt vielmehr können die Merkmale der einzelnen Ausführungsformen soweit technisch sinnvoll beliebig miteinander kombiniert werden.

### Bezugszeichenliste

- 1: Trägersubstrat
- 2a, 2b: Leiterbahn
- 3, 3a, 3a', 3b, 3b': NTC-Element
- 4, 4a, 4b: Metallisierung
- 5, 5a, 5b: elektrisch leitende Brücke
- 6: Kontaktbereich

## Patentansprüche

1. Sensorvorrichtung, aufweisend
- ein keramisches Trägersubstrat (1),
- wobei auf dem Trägersubstrat (1) wenigstens zwei Leiterbahnen (2a, 2b) angeordnet sind,
**dadurch gekennzeichnet dass**
- die Sensorvorrichtung wenigstens zwei keramische Bauelemente in Chipform aufweist, die mit den Leiterbahnen (2a, 2b) elektrisch leitend verbunden sind,
- wobei die wenigstens zwei keramischen Bauelemente mittels einer eingebrannten Siebdruckpaste mit den Leiterbahnen (2a, 2b) mechanisch verbunden sind,
- wobei die wenigstens zwei keramischen Bauelemente auf unterschiedlichen Leiterbahnen (2a, 2b) angeordnet sind und mittels einer elektrisch leitenden Brücke (5) miteinander verbunden sind, und
- wobei die elektrisch leitende Brücke (5) das gleiche Material umfasst wie das Trägersubstrat (1) der Sensorvorrichtung.

2. Sensorvorrichtung nach Anspruch 1, die für die Erfassung von Temperaturen bis zu 1000 °C ausgebildet ist.

3. Sensorvorrichtung nach einem der vorhergehenden Ansprüche, die wenigstens zwei in Längsrichtung des Trägersubstrats (1) beabstandete keramische Bauelemente aufweist, die jeweils mittels wenigstens einer separaten Leiterbahn (2a, 2b) elektrisch kontaktiert sind.

4. Sensorvorrichtung nach Anspruch 3, wobei die wenigstens zwei keramischen Bauelemente mittels wenigstens einer gemeinsamen Leiterbahn (2a, 2b) elektrisch kontaktiert sind.

5. Sensorvorrichtung nach einem der vorhergehenden Ansprüche, wobei die keramischen Bauelemente einen metallisierungsfreien keramischen Chip aufweisen.

6. Sensorvorrichtung nach einem der Ansprüche 1 bis 4, wobei die keramischen Bauelemente auf den Oberflächen eine vollflächige Metallisierung (4) aus elektrisch leitfähiger Siebdruckpaste aufweisen.

7. Sensorvorrichtung nach einem der Ansprüche 1 bis 4, wobei die keramischen Bauelemente eine streifenförmige Metallisierung (4a, 4b) aus elektrisch leitfähiger Siebdruckpaste aufweisen, die im Bereich zweier gegenüberliegender Seitenkanten aufgebracht ist.

8. Verfahren zur Herstellung einer Sensorvorrichtung gemäß einem der Ansprüche 1 bis 7,
bei dem auf einem bereitgestellten keramischen Trägersubstrat (1) wenigstens zwei keramische Bauelemente in Form eines Chips mittels einer einbrennbaren elektrisch leitfähigen Siebdruckpaste mit dem Trägersubstrat (1) mechanisch fest und mit auf dem Trägersubstrat (1) angeordneten Leiterbahnen (2a, 2b) elektrisch leitend verbunden werden.

9. Verfahren nach Anspruch 8, bei dem die einbrennbare elektrisch leitfähige Siebdruckpaste auf das Trägersubstrat (1) und auf wenigstens einen Anschlussbereich der keramischen Bauelemente aufgetragen wird, bei dem die aufgetragenen Siebdruckpasten des Trägersubstrats (1) und der keramischen Bauelemente verbunden werden und bei dem ein Einbrennen erfolgt.

10. Verfahren nach Anspruch 8 oder 9,
- bei dem auf dem bereitgestellten keramischen Trägersubstrat (1) eine Siebdruckpaste aufgebracht wird, die wenigstens zwei Leiterbahnen (2a, 2b) auf dem Trägersubstrat (1) ausbildet,
- wobei wenigstens zwei keramische Bauelemente auf dem Trägersubstrat (1) angeordnet werden,
- wobei die keramischen Bauelemente die Siebdruckpaste über wenigstens zwei Anschlussbereiche elektrisch kontaktieren,
- wobei anschließend die Siebdruckpaste in das keramische Trägersubstrat (1) und die keramischen Bauelemente eingebrannt wird,
- wobei die wenigstens zwei keramischen Bauelemente und die Siebdruckpaste während des Brennvorgangs eine mechanisch stabile Verbindung eingehen.

11. Verfahren nach Anspruch 8 oder 9,
- bei dem auf dem bereitgestellten keramischen Trägersubstrat (1) eine Siebdruckpaste aufgebracht wird, die wenigstens zwei Leiterbahnen (2a, 2b) auf dem Trägersubstrat (1) bildet,
- wobei die Siebdruckpaste in einem ersten Brennvorgang in das keramische Trägersubstrat (1) eingebrannt wird,
- wobei auf den Leiterbahnen (2a, 2b) anschließend wenigstens zwei keramische Bauelemente angeordnet werden, die mittels einer elektrisch leitfähigen Siebdruckpaste mit den eingebrannten Leiterbahnen (2a, 2b) verbunden werden,
- wobei die wenigstens zwei keramischen Bauelemente und die Siebdruckpaste während eines anschließenden zweiten Brennvorgangs eine mechanisch stabile Verbindung eingehen.

## Claims

1. Sensor device having
- a ceramic carrier substrate (1),
- at least two conductor tracks (2a, 2b) being arranged on the carrier substrate (1), **characterized in that**
- the sensor device has at least two ceramic components which are in chip form and are connected to the conductor tracks (2a, 2b) in an electrically conductive manner,
- the at least two ceramic components being mechanically connected to the conductor tracks (2a, 2b) by means of a screen printing paste which has been burnt in,
- the at least two ceramic components being arranged on different conductor tracks (2a, 2b) and being connected to one another by means of an electrically conductive bridge (5), and
- the electrically conductive bridge (5) comprising the same material as the carrier substrate (1) of the sensor device.

2. Sensor device according to Claim 1, which is designed to detect temperatures up to 1000°C.

3. Sensor device according to either of the preceding claims, which has at least two ceramic components which are spaced apart in the longitudinal direction of the carrier substrate (1) and are each electrically contact-connected by means of at least one separate conductor track (2a, 2b).

4. Sensor device according to Claim 3, the at least two ceramic components being electrically contact-connected by means of at least one common conductor track (2a, 2b).

5. Sensor device according to one of the preceding claims, the ceramic components having a metallization-free ceramic chip.

6. Sensor device according to one of Claims 1 to 4, the ceramic components having a full-area metallization (4) made of electrically conductive screen printing paste on the surfaces.

7. Sensor device according to one of Claims 1 to 4, the ceramic components having a metallization (4a, 4b) which is in the form of a strip, is made of electrically conductive screen printing paste and is applied in the region of two opposite lateral edges.

8. Method for manufacturing a sensor device according to one of Claims 1 to 7, in which at least two ceramic components in the form of a chip on a ceramic carrier substrate (1) provided are connected to the carrier substrate (1) in a mechanically fixed manner and to conductor tracks (2a, 2b) arranged on the carrier substrate (1) in an electrically conductive manner by means of an electrically conductive screen printing paste which can be burnt in.

9. Method according to Claim 8, in which the electrically conductive screen printing paste which can be burnt in is applied to the carrier substrate (1) and to at least one connection region of the ceramic components, in which the applied screen printing pastes of the carrier substrate (1) and of the ceramic components are connected and in which a burning-in operation takes place.

10. Method according to Claim 8 or 9,
- in which a screen printing paste is applied to the ceramic carrier substrate (1) provided and forms at least two conductor tracks (2a, 2b) on the carrier substrate (1),
- at least two ceramic components being arranged on the carrier substrate (1),
- the ceramic components electrically contact-connecting the screen printing paste via at least two connection regions,
- the screen printing paste then being burnt into the ceramic carrier substrate (1) and the ceramic components,
- the at least two ceramic components and the screen printing paste entering a mechanically stable connection during the burning process.

11. Method according to Claim 8 or 9,
- in which a screen printing paste is applied to the ceramic carrier substrate (1) provided and forms at least two conductor tracks (2a, 2b) on the carrier substrate (1),
- the screen printing paste being burnt into the ceramic carrier substrate (1) in a first burning process,
- at least two ceramic components then being arranged on the conductor tracks (2a, 2b) and being connected to the conductor tracks (2a, 2b), which have been burnt in, by means of an electrically conductive screen printing paste,
- the at least two ceramic components and the screen printing paste entering a mechanically stable connection during a subsequent, second burning process.

## Revendications

1. Dispositif de détection comprenant
- un substrat porteur (1) en céramique,
- au moins deux pistes conductrices (2a, 2b) étant disposées sur le substrat porteur (1),
**caractérisé en ce que**
- le dispositif de détection possède au moins deux composants en céramique sous forme de puces, lesquels sont reliés de manière électriquement conductrice avec les pistes conductrices (2a, 2b),
- les au moins deux composants en céramique étant reliés mécaniquement avec les pistes conductrices (2a, 2b) au moyen d'une pâte de sérigraphie cuite,
- les au moins deux composants en céramique étant disposés sur des pistes conductrices (2a, 2b) conductrices et étant reliés entre eux au moyen d'un cavalier (5) électriquement conducteur, et
- le cavalier (5) électriquement conducteur comprenant le même matériau que le substrat porteur (1) du dispositif de détection.

2. Dispositif de détection selon la revendication 1, lequel est configuré pour la détection de températures jusqu'à 1000 °C.

3. Dispositif de détection selon l'une des revendications précédentes, lequel possède au moins deux composants en céramique espacés dans le sens longitudinal du substrat porteur (1), lesquels sont mis en contact électrique respectivement au moyen d'au moins une piste conductrice (2a, 2b) séparée.

4. Dispositif de détection selon la revendication 3, les au moins deux composants en céramique étant mis en contact électrique au moyen d'au moins une piste conductrice (2a, 2b) commune.

5. Dispositif de détection selon l'une des revendications précédentes, les composants en céramique possédant une puce en céramique exempte de métallisation.

6. Dispositif de détection selon l'une des revendications 1 à 4, les composants en céramique possédant sur les surfaces une métallisation (4) recouvrant toute la surface en une pâte de sérigraphie électriquement conductrice.

7. Dispositif de détection selon l'une des revendications 1 à 4, les composants en céramique possédant une métallisation en forme de bandes (4a, 4b) en une pâte de sérigraphie électriquement conductrice qui est appliquée dans la zone de deux bords latéraux opposés.

8. Procédé de fabrication d'un dispositif de détection selon l'une des revendications 1 à 7,
selon lequel, sur un substrat porteur (1) en céramique mis à disposition, au moins deux composants en céramique sous la forme d'une puce sont fixés à demeure au substrat porteur (1) au moyen d'une pâte de sérigraphie électriquement conductrice pouvant être cuite et sont reliés de manière électriquement conductrice avec deux pistes conductrices (2a, 2b) disposées sur le substrat porteur (1).

9. Procédé selon la revendication 8, selon lequel la pâte de sérigraphie électriquement conductrice pouvant être cuite est appliquée sur le substrat porteur (1) et sur au moins une zone de raccordement des composants en céramique, selon lequel les pâtes de sérigraphie appliquées du substrat porteur (1) et des composants en céramique sont reliées et selon lequel une cuisson est effectuée.

10. Procédé selon la revendication 8 ou 9,
- selon lequel une pâte de sérigraphie est appliquée sur le substrat porteur (1) en céramique, laquelle forme au moins deux pistes conductrices (2a, 2b) sur le substrat porteur (1),
- au moins deux composants en céramique étant disposés sur le substrat porteur (1),
- les composants en céramique étant mis en contact électrique avec la pâte de sérigraphie par le biais d'au moins deux zones de raccordement,
- la pâte de sérigraphie dans le substrat porteur (1) en céramique et les composants en céramique étant ensuite cuite,
- les au moins deux composants en céramique et la pâte de sérigraphie entrant dans une liaison mécaniquement stable pendant l'opération de cuisson.

11. Procédé selon la revendication 8 ou 9,
- selon lequel une pâte de sérigraphie est appliquée sur le substrat porteur (1) en céramique, laquelle forme au moins deux pistes conductrices (2a, 2b) sur le substrat porteur (1),
- la pâte de sérigraphie étant cuite dans le substrat porteur (1) en céramique au cours d'une première opération de cuisson,
- au moins deux composants en céramique étant ensuite disposés sur les pistes conductrices (2a, 2b), lesquels sont reliés aux pistes conductrices (2a, 2b) cuites au moyen d'une pâte de sérigraphie électriquement conductrice,
- les au moins deux composants en céramique et la pâte de sérigraphie entrant dans une liaison mécaniquement stable pendant une deuxième opération de cuisson qui suit.
